# EUROPEAN PATENT APPLICATION

(11) **EP 4 383 490 A1**
(43) Date of publication of application: **12.06.2024**
(21) Application number: 22212489.3
(22) Date of filing: 09.12.2022
(51) Int. Cl.: H02G 15/04

(54) **TESTING ASSISTING DEVICE FOR A CABLE AND METHOD OF PROVIDING A TESTING ASSISTING DEVICE**

(71) Applicant: NKT HV Cables AB, 371 60 Lyckeby (SE)
(72) Inventor: QUIST, Tobias, Nättraby (SE); BOPPA VENKATA, Santhosh, Karlskrona (SE); JOHANNESSON, Kenneth, Lyckeby (SE); FÄLTH, Fredrik, Lund (SE); HEDBÄCK, Lars, Helsingborg (SE)
(74) Representative: Kransell & Wennborg KB

(57) **Abstract**

A testing assisting device (42) comprises a first end of a cable, an insulation body comprising a channel centred around and stretching along a longitudinal axis through the insulation body and a channel closing element (16), the channel being accessible via a first opening in the insulation body, wherein the first cable end extends into the channel via the first opening and a first end of the channel closing element (16) abuts a first end of a conductor (12) of the first cable end at a mating location in the channel in order to form an interface between the first end of the channel closing element (16) and the first end of the conductor (12) of the first cable end at the mating location. There is also a method of forming the testing assisting device (42).

## Description

### TECHNICAL FIELD

The present disclosure generally relates to a testing assisting device as well as to a method of providing a testing assisting device.

### BACKGROUND

Power cables, such as submarine power cables, may need to be tested. The cables may for instance be subjected to so-called factory acceptance tests (FAT). In order to perform such tests, both cable ends of a cable are typically prepared with cable terminations, such as outdoor terminations or gas insulated switchgear (GIS) terminations for obtaining a testing assisting device. The outdoor termination has an exposed high voltage part and therefore needs a safe zone of several meters in all directions. On the other hands, a GIS termination requires handling of SF₆, a gas with high greenhouse potential. Furthermore, it may be cumbersome to access enough length on both the ends of a produced cable for routine/FAT testing.

It would therefore be of interest to obtain a testing assisting device, which does not require the handling of environmentally unfriendly gases, such as SF₆, and/or where the need for a large safe zone is avoided. It may also be desirable to avoid the need for long lengths of conductor at both ends of a cable.

### SUMMARY

Aspects of the invention are directed towards proving a simplified testing assisting device.

The inventors have realised that an insulating body, which is normally used for jointing two cable ends, can be a basis for use instead of a cable termination. This allows a simpler testing assisting device to be provided compared with the use of a cable termination.

There is hence according to a first aspect of the present disclosure provided a testing assisting device comprising:
a first end of a cable, an insulation body comprising a channel centred around and stretching along a longitudinal axis through the insulation body and a channel closing element, the channel being accessible via a first opening in the insulation body,
wherein the first cable end extends into the channel via the first opening and a first end of the channel closing element abuts a first end of a conductor of the first cable end at a mating location in the channel, thereby forming an interface between the first end of the channel closing element and the first end of the conductor of the first cable end at the mating location.

The first cable end may have a first longitudinal axis, the channel closing element may have a second longitudinal axis and the first longitudinal axis may be aligned with the second longitudinal axis.

The testing assisting device may further comprise a conductive connector, for instance a metallic connector, having a hollow interior into which an exposed part of the conductor is inserted and at or in which the interface is located.

The insulating body may be a termination body, the channel closing element may be an insulating channel closing element and a first part of the insulating channel closing element may also abut a first end of the conductive connector.

Alternatively, the insulating body may be a joint body having a second opening via which the channel can be accessed, the channel closing element may be an insulating plug extending into the channel from the second opening and the first cable end and the insulating plug may together form an end plug assembly comprising the interface.

The end plug assembly may additionally have a shape that is adapted to the shape of the channel.

The channel may have a first part stretching between the first opening and the mating location and a second part stretching between the second opening and the mating location. The cable end may have a shape that is adapted after the shape of the first part of the channel. The insulating plug may have a shape that is adapted after the shape of the second part of the channel and a length allowing the first end of the insulating plug to be at the mating location.

A first part of the insulating plug may also extend into the hollow interior of the conductive connector.

The conductive connector may be cylindrical and may have a first end configured to abut a shoulder of the insulating plug. The first part of the insulating plug may rest on the shoulder. The conductive connector may also have a second end configured to abut an end of an insulation system of the first cable end.

The radius of the first part of the insulating plug may be the same as the radius of the conductor of the first cable end and the inner radius of the conductive connector.

The conductive connector may form the end plug assembly together with the first cable end and the insulating plug. In this case the first part of the insulating plug may also be located in the hollow interior of the conductive connector.

The insulating body may further comprise an inner rubber deflector covering and provided radially outside of the mating location.

The insulating body may further comprise field grading layers on opposite sides of the inner rubber deflector along the longitudinal axis of the insulating body, which field grading layers are configured to surround a second part of the channel closing element and the insulating system of the first cable end.

The insulating body may further comprise an outer insulating layer provided radially outside of the inner rubber deflector.

The insulating body may also comprise a first and a second outer semiconducting layer on opposite sides of the joint insulating layer along the longitudinal axis of the insulating body and each outer semiconducting layer being located radially outside a corresponding field grading layer.

When the insulating body is a termination body, the first and second outer semiconducting layers may be parts of an outer semiconducting cover that may cover and enclose the channel enclosing element, the inner rubber deflector, the field grading layers and the outer insulation layer.

The testing assisting device may also comprise a grounded electrically conducting enclosure around the insulating body.

When the insulating body is a termination body, the electrically conducting enclosure may be provided through the outer semiconducting cover.

When the insulation body is a joint body, the electrically conducting enclosure may be provided through a metallic mesh configured to enclose the insulating plug and joint body.

There may additionally be a testing device configured to be connected to a second end of the cable.

According to a second aspect of the present disclosure, there is provided a method of providing a testing assisting device comprising:
sliding an insulating body onto an end plug assembly via a first opening in the insulating body or sliding the end plug assembly onto the insulating body via the first opening, the first opening leading to a channel centred around and stretching along a longitudinal axis through the insulating body and the end plug assembly comprising a first end of a cable having a conductor with a first end, the sliding being performed until the first end of the conductor is located at a mating location in the channel, at which mating location the first end of the conductor abuts a channel closing element.

If the insulating body is a joint body and the channel closing element is an insulating plug, the method may further comprise assembling the insulating plug and the first cable end into the end plug assembly so that the first end of the insulating plug abuts the first end of the conductor of the first cable end.

In this case the sliding of the joint body onto the end plug assembly or the sliding of the end plug assembly onto the insulating body may be made until an interface between the first end of the insulating plug and the first end of the conductor is located at the mating location inside the joint body. The sliding may additionally be made until the insulating plug extends out from the channel via a second opening of the joint body.

The assembling may furthermore comprise aligning a longitudinal axis of the insulating plug with a longitudinal axis of the first cable end.

The assembling may additionally comprise assembling the insulating plug, the first cable end and a conductive connector into the end plug assembly.

In this case the assembling may furthermore comprise placing a first part of the insulating plug and an exposed part of the conductor of the first cable end in a hollow interior of the conductive connector.

The method may additionally comprise providing a grounded electrically conducting enclosure for the insulating body.

The providing of a grounded electrically conducting enclosure may comprise placing a metallic mesh around the insulating body and channel closing element and grounding the metallic mesh.

The insulating body may also be a termination body. The termination body may also comprise an outer semiconducting cover that covers and encloses the channel enclosing element as well as other layers inside the termination body, such as an inner rubber deflector, field grading layers and an outer insulation layer. In this case the providing of a grounded electrically conducting enclosure may comprise grounding the outer semiconducting cover.

Generally, all terms used in the claims are to be interpreted according to their ordinary meaning in the technical field, unless explicitly defined otherwise herein. All references to "a/an/the element, apparatus, component, means, etc." are to be interpreted openly as referring to at least one instance of the element, apparatus, component, means, etc., unless explicitly stated otherwise.

### BRIEF DESCRIPTION OF THE DRAWINGS

The specific embodiments of the inventive concept will now be described, by way of example, with reference to the accompanying drawings, in which:
Fig. 1a schematically shows a longitudinal section of a first cable end;
Fig. 1b schematically shows a longitudinal section of a first type of channel closing element realized as an insulating plug;
Fig. 1c schematically shows a longitudinal section of a conductive connector,
Fig. 1d schematically shows a longitudinal section of a first type of insulation body in the form of a joint body,
Fig. 1e schematically shows a longitudinal section of a first type of end plug assembly formed by the first cable end, the insulating plug and the conductive connector,
Fig. if schematically shows a longitudinal section of a first type of cable testing assisting device comprising the end plug assembly, the joint body and a metallic mesh;
Fig. 2 schematically shows flow chart of a number of method steps in a method of forming the testing assisting device, and
Fig.3 schematically shows a longitudinal section of a second type of cable testing assisting device comprising a second type of channel closing element, a second type of end plug assembly and a second type of insulation body in the form of a termination body.

### DETAILED DESCRIPTION

The inventive concept will now be described more fully hereinafter with reference to the accompanying drawings, in which exemplifying embodiments are shown. The inventive concept may, however, be embodied in many different forms and should not be construed as limited to the embodiments set forth herein; rather, these embodiments are provided by way of example so that this disclosure will be thorough and complete, and will fully convey the scope of the inventive concept to those skilled in the art. Like numbers refer to like elements throughout the description.

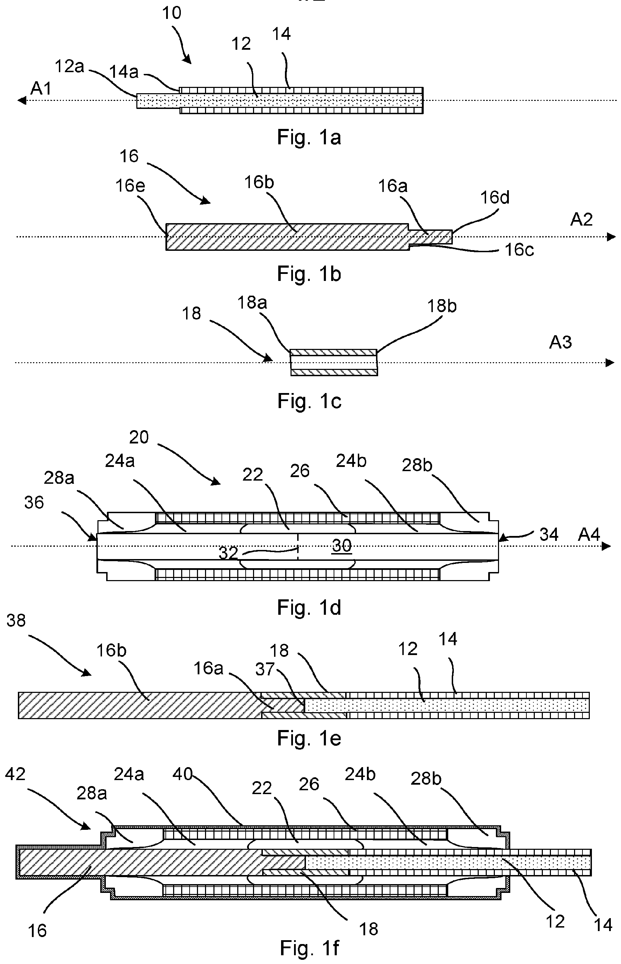

Fig. 1a shows a longitudinal section of an exemplifying first cable end 10. The cable end 10 comprises a conductor 12 that is centred around a first longitudinal axis A1. The conductor 12 is radially surrounded by an insulating system 14, where the conductor 12 has a first end 12a that is to be mated with a first end of another element. Also, the insulating system 14 has a first end 14a that is to be mated with an end of a different element. The insulating system 14 also has a thickness that is defined by an inner and an outer radius. Moreover, in the present example part of the insulating system 14 has been removed from the conductor 12, so that an exposed part of the conductor 12 stretches out in a first direction along the first longitudinal axis A1 beyond the first end 14a of the insulating system 14. The first end 12a of the conductor 12 is thereby also axially displaced in a first direction from the first end 14a of the insulating system 14.

The conductor 12 may for example be made of copper or aluminium, while the insulating system 14 may comprise an inner semiconducting layer arranged radially outside of the conductor, an insulation layer arranged radially outside of the inner semiconducting layer, and an outer semiconducting layer arranged radially outside of the insulation layer. The insulation system may hence be a triple layer insulation system. The insulation layer may for example comprise cross-linked polyethylene (XLPE) or polypropylene. Other alternatives are EPDM rubber, EPR, or polypropylene. The semiconductive layers may in turn comprise the same type of materials to which conductive particles, such as carbon back, have been added,

Fig. 1b schematically shows a longitudinal section of a first type of channel closing element in the form of an insulating plug 16, which plug 16 is centred around a second longitudinal axis A2. The plug 16 has two parts, a first part 16a with a first circular cross-section and a second part 16b with a second circular cross-section, where the radius of the first part 16a is smaller than the radius of the second part 16b. The radius of the first part 16a is additionally essentially the same as the radius of the cable conductor 12. The first part 16a rests on a shoulder 16c of the second part 16b and provides a first end 16d of the insulating plug 16. Thereby the first end 16d is axially displaced in a second direction along the second longitudinal axis A2 from the shoulder 16c, which second direction is the opposite of the first direction. The distance of this axial displacement from the shoulder 16c may with advantage be the same as the distance of the axial displacement of the first end 12a of the conductor 12 from the first end 14a of the insulating system 14. The insulating plug 16 also has a second end 16e at the second part 16b, which second end 16e is axially located opposite of the first end 16d.

The insulating plug 16 may be made of solid cross-linked polyethylene (XLPE) or polypropylene with the same outer dimension and surface preparation as the cable end. Another alternative is to use thermoplastic (non-crosslinked) polyethylene. As an alternative it is also possible to use ceramics, such as porcelain. The insulating plug 16 may also need to have a high dielectric strength, due to the high electric field formed in the joint body and be mechanically solid to permit installation and possible to reuse.

Fig. 1c shows a longitudinal section of a conductive connector 18 that is centred around a third longitudinal axis A3. The conductive connector 18 may be a metallic connector, for instance of copper or aluminium. It may additionally be cylindrical and essentially have the same radius, inner and outer, as the insulating system 14 of the cable end 10. The outer radius may also essentially be the same as the radius of the second part 16b of the plug 16, while the inner radius may be essentially the same as the radius of the first part 16a of the insulating plug 16 and the radius of the conductor 12 of the cable end 10. The inner radius of the conductive connector 18 may also define a hollow interior that is to receive the first part 16a of the insulating plug 16 and the exposed part of the conductor 12 of the cable end 10. The first part 16a of the insulating plug 16 may fit inside a first half of the conductive connector 18, while the exposed conductor 12 may fit inside a second half. The conductive connector 18 thereby has a first end 18a via which the first part 16a of the insulating plug 16 is to be accommodated and a second end 18b via which the uncovered or exposed part of the conductor 12 of the cable end 10 is be accommodated. The first end 18a of the conductive connector 18 is additionally to mate with the shoulder 16c of the insulating plug 16, while the second end 18b is to mate with the first end 14a of the insulating system 14 of the cable end 10.

Fig. id schematically shows a longitudinal section of a first type of insulating body in the form of a joint body 20. The joint body has a first and a second opening 34, 36 between which a channel 30 is defined. Thereby the channel is accessible via the first and second openings 34, 36 in the joint body 20. The channel 30 is centred around and stretches along a fourth longitudinal axis A4 of the joint body 20. The channel 30 has a radius that is essentially the same as the radius of the second part 16b of the insulating plug 16 and the outer radius of the insulating system 14 of the cable end 10. In the middle of the channel 30 between the first and second openings 34, 36 there is also a mating location 32. The channel 30 has a first part stretching between the first opening 34 and the mating location 32 and a second part stretching between the second opening 36 and the mating location 32.

The joint body 20 also comprises an inner rubber deflector 22 that is made of semiconducting material. The inner rubber deflector 22 forms part the channel wall that is centred around the mating location 32. The inner rubber deflector 22 thereby covers and is provided radially outside of the mating location 32. It is also centred around the mating location 32.

On opposite sides of the inner rubber deflector 22 along the fourth longitudinal axis A4 there is arranged a first and a second field grading layer 24a, 24b. Each field grading layer may comprise a rubber comprising a filler material to provide an electrical field grading property. The first field grading layer 24a, the inner rubber deflector 22 and the second field grading layer 24b together form the wall of the channel 30.

Radially outside of the first field grading layer 24a, the inner rubber deflector 22 and the second field grading layer 24b in an axial direction from the second opening 36 to the first opening 34 along the fourth longitudinal axis A4 are provided a first outer semiconducting layer 28a, an outer insulating layer 26 and a second outer semiconducting layer 28b. The outer insulating layer 26 is in the case a joint insulating layer and may for example comprise a polymeric material such as XLPE, EPDM, EPR or polypropylene. The outer semiconducting layers may be made of rubber and to which conducting particles, such as carbon black, have been added. There is thus a joint insulating layer 26 provided radially outside of the inner rubber deflector 22 as well as outer semiconducting layers 28a, 28b on opposite sides of the joint insulating layer 26 along the fourth longitudinal axis A4, where each outer semiconducting layer 28a, 28b is located radially outside a corresponding field grading layer 24a, 24b.

Fig. 1e schematically shows a longitudinal section through a first type of end plug assembly 38 formed through the cable end 10, the insulating plug 16 and the conductive connector 18.

The first, second and third longitudinal axes A1, A3, A3 are here aligned with each other. The first longitudinal axis A1 is thus aligned with the second longitudinal axis A2 and the third longitudinal axis A3. The first part 16a of the insulating plug 16 is inserted in the hollow interior of the conductive connector 18 from the first end 18a and the exposed part of the conductor 12 of the cable end 10 is inserted in the hollow interior of the conductive connector 18 from the second end 18b. The first part 16a of the insulating plug 16 and the exposed part of the conductor 12 thus extend into the hollow interior of the conductive connector 18. It can be seen that the first end 16d of the insulating plug 16 abuts the first end 12a of the conductor 12 of the cable end 10. Thereby there is an interface 37 between the first end 16d of the insulating plug 16 and the first end 12a of the conductor 12 of the cable end 10 located in the hollow interior of the conductive connector 18. The first end 18a of the conductive connector 18 in this case also abuts the shoulder 16c of the insulating plug 16 and the second end 18b of the connector 18 abuts the first end 14a of the insulation system 14 of the cable end 10.

The end plug assembly 38 also has a shape that is adapted to the shape of the channel 30 of the joint body 20. The insulating plug 16 may have a shape that is adapted after the shape of the second part of the channel 30 and a length allowing the first end 16d of the insulating plug 16 to be at the mating location 32 of the joint body 20 when the plug 16 is located in the second part of the channel 30. The cable end 10 may in turn have a shape that is adapted after the shape of the first part of the channel and a length allowing the first end 12a of the conductor 12 to be at the mating location 32 of the joint body 20 when the cable end 10 is located in the first part of the channel 30.

Fig. if schematically shows the end plug assembly 38 that has been formed through the insulating plug 16, conductive connector 18 and the cable end 10 inserted into the joint body 20 for forming the testing assisting device 42. The plug 16 and cable end 10 are thus located in the joint body 20. The first cable end 10 extends into the channel 30 via the first opening 34, while the insulating plug 16 extends into the channel 30 from the second opening 36. Moreover, the first end 16d of the insulating plug 16 abuts the first end 12a of the conductor 12 of the first cable end 10 at the mating location 32 in the channel 30. Thereby, it can also be seen that the interface 37 between the first end 16d of the insulating plug 16 and the first end 12a of the conductor 12 of the cable end 10 is located at the mating location 32 of the channel 30. It can also be seen that the field grading layers 24a, 24b surround the insulating plug 16 and the insulating system 14 of the cable end 10. The insulating plug 16 and joint body 20 are also covered by a metallic mesh 40. The metallic mesh 40 thus encloses the insulating plug 16 and the joint body 20.

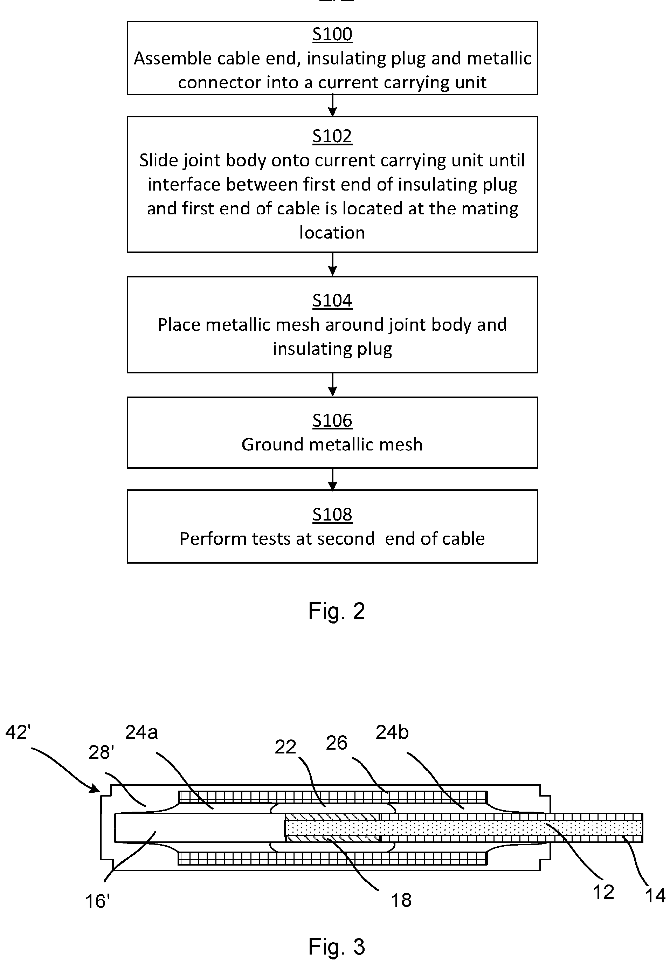

How this may be achieved, will now be described with reference also being made to fig. 2, which shows a flow chart of a number of method steps in a method of providing the testing assisting device 42.

The method comprises assembling the cable end 10, the insulating plug 16 and the conductive connector 18 into an end plug assembly 38 so that the first end 16d of the insulating plug 16 abuts the first end 12a of the conductor 12 of the cable end 10, S100. This may involve aligning the first longitudinal axis A1 of the cable end 10 with the second longitudinal axis A2 of the insulating plug 16 and also with the third longitudinal axis A3 of the conductive connector 18. The assembling may additionally comprise placing the first part 16a of the insulating plug 16 and the exposed part of the conductor 12 of the cable end 10 in the hollow interior of the conductive connector 18.

The assembling may involve sliding the hollow interior of the conductive connector 18 onto the exposed conductor 12 of the cable end 10 or vice versa until the second end 18b of the conductive connector 18 abuts the first end 14a of the insulating system 14 of the cable end 10. Thereby the interface 37 between the first end 16d of the insulating plug 16 and the first end 12a of the conductor 12 is also formed. The forming of the end plug assembly 38 may thereby comprise placing the second end 18b of the conductive connector 18 in abutment with the first end 14a of the insulating system 14. The forming of the end plug assembly 38 may additionally involve inserting the first part 16a of the insulating plug 16 in the hollow interior of the conductive connector 18 at the first end 18a of this connector 18 or vice versa until the shoulder 16c of the insulating plug 16 abuts the first end 18a of the conductive connector 18 and the first end 16d of the insulating plug 16 abuts the first end 12a of the conductor 12 of the cable end 10. The forming of the end plug assembly 38 may thereby comprise placing the shoulder 16c of the insulating plug 16, on which the first part 16a rests, in abutment with the first end 18a of the conductive connector 18.

The method comprises sliding the joint body 20 onto the end plug assembly 38 via the first opening 34 or sliding the end plug assembly 38 onto the joint body 20 via the first opening 34 until the interface 37 between the first end 16d of the insulating plug 16 and the first end 12a of the conductor 12 is located at the mating location 32 inside the joint body 20, S102. The sliding may additionally be made until the insulating plug 16 extends out from the channel 30 via the second opening 36 of the joint body 20. The sliding may involve sliding the joint body onto the end plug assembly 38 so that the end plug assembly 38 enters the channel 30 in the joint body 20 via the first opening 34. This may be done through placing the first opening 34 of the joint body 20 over the second end 16e of the insulating plug 16b and moving the channel 30 of the joint body 20 until the mating location 32 reaches the interface 37, i.e. until the first end 12a of the conductor 12 is located at the mating location 32. Thereby the joint body 20 may be threaded onto the end plug assembly 38 until the mating location 32 reaches the interface 37.

The method may additionally comprise providing a grounded electrically conducting enclosure for the joint body 20.

The providing of a grounded electrically conducting enclosure may comprise placing a metallic mesh 40, such as a copper or aluminium mesh, around the joint body 20 and the insulating plug 16, S104, in order to obtain the structure shown in fig. if.

After the installation is completed, the testing assisting device 42 may be placed directly on a turntable or on a floor of a testing environment.

The providing of a grounded electrically conducting enclosure may also comprise grounding the mesh 40, S106.

The device may be used when performing tests on the cable from a second end of the cable, such as FAT tests, S108. This maybe done through a testing device that is connected to a second end of the cable, for instance via a cable termination, applying suitable voltages to the conductor 12.

Examples of other tests than FAT tests are charge tests, routine tests, impulse tests that do not require pre-stress and after installation tests, which after installation test may be performed on a sea cable onto a cable laying vessel. Here, the testing assisting device is placed on the vessel. Since there would be no exposed high voltage onboard the vessel, this invention would greatly reduce the risk and save lots of space.

Thus, when applicable, the testing assisting device can be used for assisting in tests that are made on a power cable. More particularly, it can replace a regular cable termination. This can lead to a saving of material, work-space, safety area size and installation time. It may also avoid the need for long conductor lengths at both ends of the cable.

Simulations made on the testing assisting device show that it is safe to use as a small and simple cable termination.

Some advantages with this invention are:
- Safer installation - Safer in testing, no exposed high voltage parts
- Faster installation - Only one joint body, short cable end preparation.
- Saves test space - Since there is no flashover risk, the joint body can be placed onto the cable stack, or the test hall floor.

In the example given above, the insulating body was a joint body normally used for jointing two cable ends. It should be realized that as an alternative the insulating body may be a terminating body and in this case the channel only has one opening, such as the second opening.

One example of a second type of testing assisting device 42' using a termination body as a joint body is shown in fig. 3, which schematically shows a longitudinal section of the second type of cable testing assisting device comprising a second type of channel closing element, a second type of end plug assembly and a second type of insulation body in the form of a termination body.

The termination body does in many respects have the same type of realization as the previously described joint body 20. However, in this case the channel only has the first opening 34. Moreover, the insulating channel closing element 16' is provided as a part of and in the interior of the body. Also, there is a single outer semiconducting cover 28' that has a first and a second layer similar to the previously described first and second outer semiconducting layers 28a, 28b. However, in this case the outer semiconducting cover 28' also covers the whole of the termination body in a similar way to the previously described mesh 40.

The outer semiconducting cover 28' thus comprises a first and a second layer on opposite sides of the outer insulating layer 26 along the longitudinal axis of the insulating body, where each part of the outer semiconducting cover is located radially outside a corresponding field grading layer.

In this case the outer semiconducting cover 28' thus covers and encloses the channel enclosing element 16', the inner rubber deflector 22, the field grading layers 24a, 24b and the outer insulating layer 26.

Furthermore, the channel closing element 16' does in this case have a first and a second part, where the first part provides the first end and the second part provides the second end. However, in this case the first and second parts have the same radius and the first part is surrounded by the inner rubber deflector 22, while the second part is surrounded by the first field grading layer 24a. Furthermore, in this case the first end of the insulating channel closing element 16' may abut the first end of the conductive connector 18 in addition to the first end of the conductor 12, while the second end of the insulating channel closing element 16' may abut the outer semiconducting cover 28'. Also, the mating location as well as the interface between the first end of the channel closing element 16' and the first end 12a of the conductor 12 of the first cable end 10 is provided at this first end of the conductive connector 18.

In this case it is thus possible that the grounded outer semiconducting rubber surrounds the entire termination body, except for the first opening where the cable end is inserted. Since the body only has one hole, it can no longer be installed as a standard joint. Instead, an end plug assembly only comprising the cable end may be inserted into the termination body by pushing. It is probably good to still have a conductive connector 18, modified or not, in order for the cable conductor 12 to electrically connect to the inner rubber deflector 22. The connector 18 can either be pre-installed on the cable end, or permanently fixed inside the termination, in which case the electric contact may be achieved by e.g. springs. Since the termination body only has one opening, the air trapped inside may need to be allowed to escape. This could be achieved by, for example, prolonging plastic fingers used when sliding the termination body onto the cable end, thus creating channels for the air to escape.

There exist a number of possible variations to the first and the second embodiments. It is for instance possible that the conductive connector is omitted from the end plug assembly. It can for instance be provided as a part of the joint body instead. It is also possible that it is omitted altogether.

In the second embodiment, the end plug assembly only included the cable end, in which no assembly of the end plug assembly is made. However, it should be realized that it is possible to assemble an end plug assembly also with the termination body. In this case an end plug assembly may be formed through combining the first cable end with the channel closing element and/or the conductive connector. The conductive connector may thus be a part of an end plug assembly or the termination body. Of course, the conductive connector can also in this case be omitted altogether.

Finally, it has to be noted that the invention is not limited to the examples mentioned above. It is applicable to all joints, both DC and AC and for extruded and mass impregnated (MI) cables. The invention may additionally include other material combinations apart from those already mentioned,

The inventive concept has mainly been described above with reference to a few examples. However, as is readily appreciated by a person skilled in the art, other embodiments than the ones disclosed above are equally possible within the scope of the inventive concept, as defined by the appended claims.

## Claims

1. A testing assisting device (42; 42') comprising:
a first end (10) of a cable, an insulating body (20) comprising a channel (30) centred around and stretching along a longitudinal axis (A4) through the insulation body and a channel closing element (16; 16'), the channel (30) being accessible via a first opening (34) in the insulation body,
wherein
the first cable end (10) extends into the channel (30) via the first opening (34) and a first end (16d) of the channel closing element (16; 16') abuts a first end (12a) of a conductor (12) of the first cable end (10) at a mating location (32) in the channel (30) in order to form
an interface (37) between the first end (16d) of the channel closing element (16; 16') and the first end (12a) of the conductor (12) of the first cable end (10) at the mating location (32).

2. The testing assisting device (42; 42') as claimed in claim 1, wherein the first cable end (10) has a first longitudinal axis (A1), the channel closing element (16; 16') has a second longitudinal axis (A2) and the first longitudinal axis (A1) is aligned with the second longitudinal axis (A2).

3. The testing assisting device (42) as claimed in claim 1 or 2, wherein the channel (30) comprises a second opening (36), the insulating body (20) is a joint body, the channel closing element is an insulating plug (16) extending into the channel (30) from the second opening (36) and the first cable end (10) and the insulating plug (16) together forming an end plug assembly (38) comprising said interface (37) at which the first end (16d) of the insulating plug (16) abuts the first end (12a) of the conductor (12) of the first cable end (10).

4. The testing assisting device (42; 42') as claimed in any previous claim, further comprising a conductive connector (18) the conductive connector (18) having a hollow interior into which an exposed part of the conductor (12) is inserted and at or in which said interface (37) is located.

5. The testing assisting device (42) as claimed in claim 4 when depending on claim 3, wherein the conductive connector (18) is forming the end plug assembly (38) together with the first cable end (10) and the insulating plug (16), and where a first part (16a) of the insulating plug (16) is also located in the hollow interior of the conductive connector (18).

6. The testing assisting device (42') as claimed in claim 4, wherein the insulating body (20) is a termination body, the channel closing element is an insulating channel closing element (16') and a first part of the insulating channel closing element (16') abuts a first end (18a) of the conductive connector (18).

7. The testing assisting device (42; 42') as claimed in any previous claim, further comprising a grounded electrically conducting enclosure (40; 28') around the insulating body.

8. The testing assisting device (42) as claimed in claim 7, when depending on claim 3, wherein the electrically conducting enclosure is provided through a metallic mesh (40) configured to enclose the insulating plug (16) and joint body (20).

9. The testing assisting device (42; 42') as claimed in any previous claim, further comprising a testing device configured to be connected to a second end of the cable.

10. A method of providing a testing assisting device (42; 42'), the method comprising
sliding (S102) an insulating body (20) onto an end plug assembly (38) via a first opening (34) in the insulating body (20) or sliding the end plug assembly (38) onto the insulating body (20) via the first opening (34), the first opening (34) leading to a channel (30) centred around and stretching along a longitudinal axis (A4) through the insulating body (20) and the end plug assembly (38) comprising a first end (10) of a cable having a conductor (12) with a first end (12a), said sliding being performed until the first end (12a) of the conductor (12) is located at a mating location (32) in the channel (30), at which mating location the first end of the conductor abuts a channel closing element (16; 16').

11. The method according to claim 10, wherein the insulating body (20) is a joint body, the channel closing element is an insulating plug (16) and further comprising assembling (S100) the insulating plug (16) and the first cable end (10) into the end plug assembly (38) so that a first end (16d) of the insulating plug (16) abuts a first end (12a) of the conductor (12) of the first cable end (10), and where the sliding (S102) of the joint body (20) onto the end plug assembly (38) or the sliding of the end plug assembly (38) onto the insulating body (20) is made until an interface (37) between the first end (16d) of the insulating plug (16) and the first end (12a) of the conductor (12) is located at the mating location (32) inside the joint body (20).

12. The method as claimed in claim 11, wherein the assembling comprises assembling the insulating plug (16), the first cable end (10) and a conductive connector (18) to the end plug assembly (38).

13. The method according to claim 12, wherein the assembling comprises placing a first part (16a) of the insulating plug (16) and an exposed part of the conductor (12) of the first cable end (10) in a hollow interior of the conductive connector (18).

14. The method as claimed in any of claims 10 - 13, further comprising providing (S104, S106)) a grounded electrically conducting enclosure for the insulating body (20).

15. The method according to claim 14, wherein the providing of a grounded electrically conducting enclosure comprises placing (S104) a metallic mesh (40) around the insulating body (20) and channel closing element (16) and grounding (S106) the metallic mesh (40).
